# FASCICULE DE BREVET EUROPEEN

(11) **EP 2 736 088 B1**
(45) Date de publication et mention de la délivrance du brevet: **04.01.2017**
(21) Numéro de dépôt: 13194389.6
(22) Date de dépôt: 26.11.2013
(51) Int. Cl.: H01L 45/00

(54) **Dispositif électronique de type mémoire**
Elektronische Vorrichtung vom Typ Speicher
Electronic device such as a memory

(30) Priorité: 27.11.2012 FR 1261260
(43) Date de publication de la demande: 28.05.2014
(73) Titulaire: COMMISSARIAT A L'ENERGIE ATOMIQUE ET AUX ENERGIES ALTERNATIVES, 75015 Paris (FR)
(72) Inventeur: Molas, Gabriel, 38000 Grenoble (FR); Nodin, Jean-François, 38950 Quaix en Chartreuse (FR)
(74) Mandataire: Lebkiri, Alexandre

(56) Documents cités:
- EP-A2- 2 141 753
- WO-A2-2013/006363
- US-A1- 2007 139 987
- US-A1- 2008 314 738
- US-A1- 2010 006 813
- US-A1- 2010 117 052
- US-A1- 2010 193 762
- US-A1- 2011 120 856
- US-A1- 2012 267 597

## Description

La présente invention concerne un dispositif électronique de type mémoire ; l'invention concerne plus particulièrement le domaine des mémoires réinscriptibles, et plus spécifiquement celui des mémoires réinscriptibles non volatiles résistive à conduction ionique (mémoires CBRAM ou « Conductive Bridging RAM »).

En fonction des applications et des performances visées, différents types de mémoires sont utilisées.

Ainsi, les mémoires de type SRAM, ou mémoires vives statiques, offrent des temps d'écriture ultra-rapides, requis par exemple lors de calculs par un micro-processeur. L'inconvénient majeur de ces mémoires est qu'elles sont volatiles et que la taille du point mémoire relativement grande ne permet pas d'obtenir une grande capacité de stockage dans un volume raisonnable.

Les mémoires de type DRAM, ou mémoires vives dynamiques, réalisant le stockage de charges électriques dans des capacités, offrent une grande capacité de stockage. Ces mémoires possèdent toutefois des temps d'écriture plus élevés (quelques dizaines de nanosecondes) que ceux des mémoires de type SRAM et sont elles-aussi volatiles, le temps de rétention de l'information étant de l'ordre de quelques dizaines de millisecondes.

A l'inverse, pour des applications qui nécessitent un stockage de l'information même lorsque la tension est coupée, on connait également des dispositifs mémoire à l'état solide qui conservent l'information en l'absence d'alimentation : ces dispositifs sont appelés mémoires non volatiles. Ainsi, depuis de nombreuses années, différentes solutions technologiques ont été développées, et ont conduit à la disponibilité de mémoires non volatiles pouvant être écrites et effacées électriquement. On peut citer par exemple :
- les EPROMs (« Erasable Programmable Read Only Memories » en anglais, ou mémoires mortes effaçables et programmables), dont le contenu peut être écrit électriquement, mais qui doivent être soumises à un rayonnement UV pour effacer les informations mémorisées ;
- les EEPROMs (« Electrically Erasable Programmable ROMs » en anglais, ou mémoires mortes effaçables et programmables électriquement), dont le contenu peut être écrit et effacé électriquement, mais qui requièrent, pour leur réalisation, des surfaces de semi-conducteur plus importantes que les mémoires de type EPROM, et qui sont donc plus coûteuses à réaliser.

Les deux solutions mentionnées ci-dessus présentant des limites dans leur application, les fabricants se sont mis à la recherche d'une mémoire non volatile idéale, qui combinerait les caractéristiques suivantes : écriture et effacement électrique, haute densité et faible coût par bit, accès aléatoire, temps d'écriture et de lecture courts, bonne endurance, mais aussi faible consommation et faible tension d'alimentation.

Il existe également des mémoires non volatiles, appelées mémoires Flash, qui ne présentent pas les inconvénients des mémoires EPROMs ou EEPROMs mentionnés ci-dessus. En effet, une mémoire Flash est formée d'une pluralité de cellules mémoires pouvant être programmées électriquement de manière individuelle, un grand nombre de cellules, appelé bloc, secteur ou page, pouvant être effacées simultanément et électriquement. Les mémoires Flash combinent à la fois l'avantage des mémoires EPROMs en termes de densité d'intégration et l'avantage des mémoires EEPROMs en termes d'effacement électrique.

De plus, la durabilité et la faible consommation électrique des mémoires Flash les rendent intéressantes pour de nombreuses applications : appareils photos numériques, téléphones cellulaires, imprimantes, assistants personnels, ordinateurs portables, ou encore dispositifs portables de lecture et d'enregistrement sonore, clés USB, etc. De plus, les mémoires Flash ne possèdent pas d'éléments mécaniques, ce qui leurs confère une assez grande résistance aux chocs. A l'ère du 'tout numérique', ces produits se sont grandement développés, permettant une explosion du marché des mémoires Flash.

La plupart des mémoires Flash non-volatiles du commerce utilisent le stockage de charges comme principe de codage de l'information. En pratique, une couche de piégeage de charge (généralement du polysilicium, ou un diélectrique comme le SiN) est encapsulée entre deux diélectriques dans l'empilement de grille d'un transistor MOS. La présence ou l'absence de charge dans ce médium modifie la conduction du transistor MOS et permet de coder l'état de la mémoire.

Plus récemment, d'autres types de mémoires non volatiles réinscriptibles sont apparus pour réduire les tensions et temps de programmation des mémoires Flash ; on peut notamment citer les mémoires ferroélectriques (mémoires FeRAM ou « Ferroelectric RAM »), basées sur le basculement de la polarisation, ou les mémoires magnétiques (mémoires MRAM ou « Magnetic RAM) qui utilisent la direction du champ magnétique rémanent dans le matériau actif. Cependant, les mémoires FeRAM et MRAM présentent des difficultés qui limitent leur réduction d'échelle.

Afin de surmonter ces difficultés, on connait les mémoires à résistance variable (appelées mémoires RRAM ou « Resistive RAM ») ; ces dernières sont aujourd'hui le sujet d'une grande attention. Les mémoires de type résistive peuvent présenter au moins deux états « off » ou « on » correspondant au passage d'un état résistif (état « OFF ») à un état moins résistif (état « ON »)).

On peut distinguer trois types de mémoires résistives : les mémoires à base de mécanisme thermochimique, les mémoires à base de changement de valence, et les mémoires à base de métallisation électrochimique.

Le domaine de la présente invention concerne cette dernière catégorie basée sur des matériaux actifs tels que des matériaux à conduction ionique que nous appellerons mémoires CBRAM ou « Conductive Bridging RAM » (ou PMC pour Programmable Metallization Cell) et dont le fonctionnement réside sur la formation et la rupture réversibles d'un filament conducteur dans un électrolyte solide, par dissolution d'une électrode soluble. Ces mémoires sont extrêmement prometteuses de par leur faibles tensions de programmation (de l'ordre du Volt), leur temps courts de programmation (<1µs), leur faible consommation, et leur faible coût d'intégration. De plus, ces mémoires peuvent être intégrées dans les niveaux de métallisation de la logique du circuit (« above IC »), ce qui permet d'augmenter la densité. Du point de vue de l'architecture, ces mémoires nécessitent généralement un dispositif de sélection pouvant être par exemple un transistor ou une diode.

Le fonctionnement des dispositifs de type CBRAM est basé sur la formation, au sein d'un électrolyte solide, d'un ou plusieurs filaments métalliques (appelés également « dendrite ») entre deux électrodes, lorsque ces électrodes sont portées à des potentiels respectifs appropriés. La formation du filament permet d'obtenir une conduction électrique donnée entre les deux électrodes. En modifiant les potentiels respectifs appliqués aux électrodes, il est possible de modifier la répartition du filament, et de modifier ainsi la conduction électrique entre les deux électrodes. En inversant par exemple le potentiel entre les électrodes, il est possible de faire disparaître ou de réduire le filament métallique, de manière à supprimer ou à réduire considérablement la conduction électrique due à la présence du filament. Les dispositifs CBRAM peuvent ainsi avoir un fonctionnement à deux états : un état dit « ON » et un état dit « OFF » et jouer ainsi le rôle de cellules mémoires.

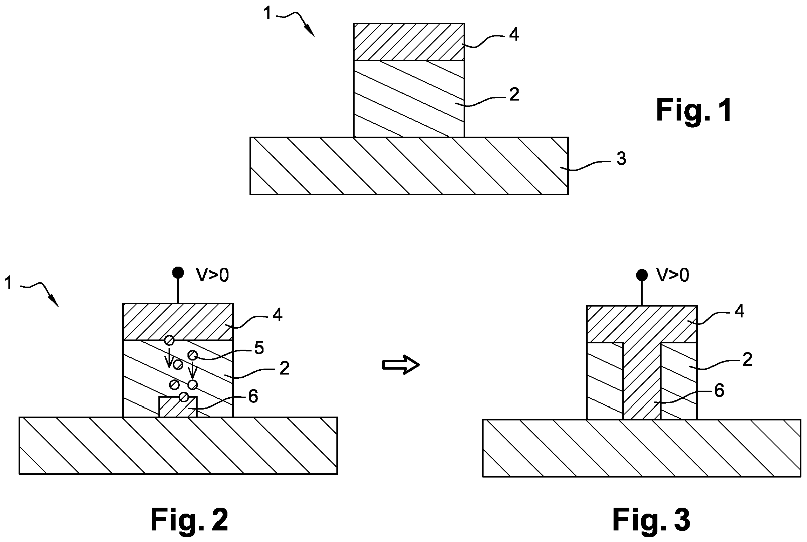

La figure 1 représente un schéma de principe d'un dispositif électronique 1 de type CBRAM.

Ce dispositif 1 est formé par un empilement de type Métal/Conducteur ionique / Métal. Il comporte un électrolyte solide 2, par exemple à base de chalcogénure dopé tel que du GeS disposé entre une électrode inférieure 3, par exemple en Pt, formant une cathode inerte, et une électrode supérieure 4 comportant une portion de métal ionisable, par exemple à base d'Ag ou de Cu, c'est-à-dire une portion de métal pouvant facilement former des ions métalliques (ici des ions argent Ag⁺ ou Cu²⁺), et formant une anode. Le dispositif 1 représenté sur la figure 1 forme typiquement un point mémoire, c'est-à-dire une cellule mémoire unitaire, d'une mémoire comportant une multitude de ces dispositifs mémoires : dans ce cas, l'électrolyte est généralement intégré en « point contact », entre les deux électrodes qui sont organisées en ligne dans des directions perpendiculaires entre elles.

L'état mémoire d'un dispositif mémoire CBRAM résulte de la différence de résistivité électrique entre deux états : ON et OFF. A l'état OFF, les ions métalliques (par exemple ici des ions Ag+ pour une électrode soluble en Ag) issus de la portion de métal ionisable sont dispersés dans tout l'électrolyte solide. Ainsi, aucun contact électrique n'est établi entre l'anode et la cathode, c'est-à-dire entre la portion de métal ionisable et l'électrode inférieure. L'électrolyte solide forme une zone électriquement isolante de grande résistivité entre l'anode et la cathode.

Lorsqu'un potentiel V positif est appliqué sur l'électrode soluble supérieure (l'anode) 4, une réaction d'oxydo-réduction a lieu à cette électrode, créant des ions mobiles 5 (Figure 2).

Dans le cas d'une électrode 4 d'Argent, la réaction suivante a lieu :

Ag → Ag⁺ + e⁻.

Il faut pour cela que le potentiel V appliqué à l'électrode soluble 4 soit suffisant pour que la réaction redox ait lieu.

Les ions 5 se déplacent alors dans l'électrolyte 2 sous l'effet du champ électrique appliqué. La vitesse de déplacement dépend de la mobilité de l'ion dans l'électrolyte en question, ce qui guide le choix du couple électrode soluble / électrolyte (exemples : Ag/GeS ; Cu/SiO2...). Les vitesses de déplacement des ions sont de l'ordre du nm/ns.

Arrivés à l'électrode inerte 3 (la cathode), les ions 5 sont réduits de par la présence d'électrons fournis par l'électrode, entraînant la croissance d'un filament métallique 6 selon la réaction suivante :

Ag⁺ + e⁻ → Ag

Ce filament croit préférentiellement dans la direction de l'électrode soluble 4.

La mémoire 1 passe alors dans l'état ON (figure 3) lorsque le filament 6 permet le contact entre les deux électrodes 3 et 4, rendant l'empilement conducteur. Cette phase est appelé SET de la mémoire.

Pour passer à l'état OFF (phase de RESET de la mémoire), une tension V négative est appliquée sur l'électrode supérieure 4, entrainant la dissolution du filament conducteur. Pour justifier cette dissolution, des mécanismes thermiques (échauffement) et d'oxydoréduction sont généralement invoqués.

De nombreuses études portent sur ces mémoires CBRAM pour améliorer leur fiabilité et leurs performances. Parmi les solutions proposées, on peut notamment citer : l'ingénierie de l'électrolyte (ajout de dopants, choix de nouveaux matériaux, recuits, traitements UV...), l'ingénierie de l'électrode soluble et de l'électrode inerte ou l'ajout d'interface(s) entre les électrodes et l'électrolyte.

Afin de réduire les dimensions des mémoires CBRAM, une architecture à base d'électrode conductrice en anneau a été proposée dans le brevet US8022547. Cette solution permet de réduire les dimensions de la zone active sans faire appel à des étapes de photolithographie critique.

Les solutions connues et mentionnées ci-dessus présentent toutefois certains inconvénients.

Ainsi, une des difficultés des mémoires filamentaires telles que les CBRAM concerne la forte dispersion de certaines caractéristiques électriques. En particulier, de fortes dispersions des tensions de SET et RESET sont mesurées au niveau des matrices mémoires, mais également sur un même dispositif, lors du cyclage de la cellule (mesure d'endurance). Cette dispersion est critique pour la fiabilité de ces dispositifs et limite leur intégration à grande échelle. On retrouve également ces limitations dans les mémoires de type OXRRAM (mémoires résistives à base d'oxyde) où le changement d'état résistif est lié à la formation d'un filament de lacunes d'oxygène. Une des origines invoquée pour expliquer cette dispersion porte sur la difficulté à contrôler la taille et la position du filament, qui peut varier d'un cycle à l'autre sur la cellule mémoire.

Le document US2011/0120856 décrit une mémoire CBRAM permettant de contrôler la forme du filament ; pour ce faire, l'électrolyte possède une forme asymétrique de sorte que la section de contact de l'électrolyte avec l'électrode soluble est inférieure à la section de contact de l'électrolyte avec l'électrode inerte. La forme des espaceurs entourant l'électrolyte combinée avec la forme de l'électrolyte permettent de bien définir la région active et donc la forme du filament conducteur.

Cette solution présente toutefois également certains inconvénients.

Ainsi, la réduction de la taille de l'électrolyte peut entraîner une dégradation des performances lorsque la taille de l'électrolyte au niveau de l'électrode soluble est proche ou égale à celle du filament que l'on souhaite créer. Par exemple pour l'effacement, il reste alors peu d'espace disponible dans l'électrolyte pour dissoudre le filament formé.

Des autres dispositifs et procédés de l'art antérieur sont décrits par US 2008 / 0314738 A1, US 2010 / 0193762 A1, EP 2 141 753 A1 et US 2010 / 0006813 A1. Le contenu du document WO 2013 / 006363 A2 est considéré comme compris dans l'état de la technique en vertu de l'art. 54(3) CBE.

L'invention vise à remédier aux inconvénients de l'état de la technique en proposant un dispositif électronique à caractéristiques électriques et cyclabilité améliorée.

Dans ce contexte, la présente invention vise à fournir un dispositif électronique selon la revendication 1 et un procédé selon la revendication 8. Par ceci, on confine à la fois l'électrolyte et l'une des électrodes (par exemple en réalisant deux cavités successives dans des matériaux diélectriques qui accueilleront respectivement l'électrolyte et l'électrode). Ce double confinement est encore plus avantageux car il permet de contrôler plus efficacement la taille et la position du filament. On utilise avantageusement un volume asymétrique pour l'électrolyte de façon à bénéficier d'un volume réduit du côté de l'électrode inerte et d'un volume plus important du côté de l'électrode soluble. On notera que cette configuration de l'électrolyte de confinement est exactement inverse de la configuration présentée dans le document US2011/0120856. En d'autres termes, on ajuste ici avantageusement la forme de l'électrolyte afin de diminuer la surface de contact avec l'électrode inerte tout en conservant un volume d'électrolyte suffisant, notamment pour l'effacement. En choisissant une telle configuration, on utilise à la fois le confinement de l'électrolyte au niveau de l'électrode inerte qui permet de contrôler la formation du filament conducteur (i.e. plus le volume de l'électrolyte est petit, plus le filament sera guidé dans sa croissance, et donc plus les caractéristiques électriques seront reproductibles) mais on conserve également un volume suffisant d'électrolyte (notamment au niveau de l'électrode soluble) pour ne pas dégrader les performances du dispositif (la taille de l'électrolyte reste supérieure à celle du filament au niveau de l'électrode soluble) ; ainsi, pour l'effacement, il reste suffisamment d'espace disponible lorsqu'on se rapproche de l'électrode soluble dans l'électrolyte pour dissoudre le filament formé.

On entend par filament conducteur au moins un nanofil ou dendrite (par exemple métallique) formé par la croissance d'ions (par exemple métalliques) au sein de l'électrolyte.

Grâce à l'invention, on réalise un confinement de l'une au moins des deux électrodes ; ce confinement permet de contrôler la formation du filament conducteur. Plus la surface de contact est réduite plus le filament sera guidé dans sa croissance et donc plus les caractéristiques électriques seront reproductibles. L'électrode de confinement est l'électrode en matériau soluble de sorte que le volume de matériau donneur d'ions est réduit. Ce confinement permet de contrôler la taille et la position du filament en le guidant dans sa croissance lors de l'opération de SET de la mémoire CBRAM. Le confinement de l'électrode supérieure permet de générer un pic de champ électrique pendant l'opération de SET assurant une croissance préférentielle verticale du filament. En d'autres termes, un effet de pointe sur l'électrode de confinement entraîne une augmentation locale du champ électrique lors de l'opération de SET permettant de guider le filament lors de sa formation et donc de réduire les dispersions de taille et de position du filament.

Le dispositif selon l'invention peut également présenter une ou plusieurs des caractéristiques ci-dessous, considérées individuellement ou selon toutes les combinaisons techniquement possibles :
- la section de l'électrode de confinement mesurée parallèlement au plan de contact de l'électrolyte avec l'électrode de confinement croit continument depuis le plan de contact sur au moins une partie de la hauteur de ladite électrode de confinement ;
- la section de l'électrolyte mesurée parallèlement au plan de contact dudit électrolyte avec la première électrode croit continument depuis le plan de contact sur au moins une partie de la hauteur de l'électrolyte ;
- l'électrolyte présente un première partie de section constante en contact avec la première électrode poursuivie par une deuxième partie de section constante, la section constante de la première partie étant inférieure à la section constante de la deuxième partie, lesdites sections constantes étant mesurées parallèlement aux plans de contact de l'électrolyte avec les première et deuxième électrodes ;
- le dispositif selon l'invention comporte des moyens isolants entourant l'électrolyte sur au moins une partie de sa hauteur ;
- le dispositif selon l'invention comporte des moyens isolants entourant l'électrode de confinement sur au moins une partie de sa hauteur ;
- l'électrolyte solide est réalisé à partir d'un matériau chalcogénure tel qu'un séléniure ou un tellurure, de certains oxydes tels que SiO₂, HfO₂, Ta₂O₅, TiO₂, GdOx, CuOx, WOx, ou de sulfures tels que GeSₓ, CuₓS ou AgS.

La présente invention a également pour objet un procédé de fabrication du dispositif selon l'invention comportant :
- une étape de réalisation d'une ouverture dans un matériau isolant, ladite ouverture ayant la forme de ladite électrode de confinement ;
- une étape de remplissage de ladite ouverture par un matériau formant ladite électrode.

Selon un premier mode de réalisation, ladite ouverture est obtenue par gravure anisotrope du matériau isolant.

Selon un second mode de réalisation, ladite ouverture est obtenue par transfert d'un motif de résine fluée dans ledit matériau isolant.

La présente invention a également pour objet un procédé de fabrication du dispositif selon l'invention comportant :
- une étape de réalisation d'une première ouverture dans un matériau isolant, ladite première ouverture ayant la forme dudit électrolyte ;
- une étape de remplissage de ladite première ouverture par un matériau formant ledit électrolyte ;
- une étape de réalisation d'une deuxième ouverture dans un matériau isolant, ladite deuxième ouverture ayant la forme de ladite électrode de confinement ;
- une étape de remplissage de ladite deuxième ouverture par un matériau formant ladite électrode.

D'autres caractéristiques et avantages de l'invention ressortiront clairement de la description qui en est donnée ci-dessous, à titre indicatif et nullement limitatif, en référence aux figures annexées, parmi lesquelles :
- les figures 1 à 3 représentent schématiquement un dispositif à conduction ionique du type CBRAM selon l'état de la technique;
- la figure 4 représente schématiquement un dispositif électronique selon un premier mode de réalisation de l'invention ;
- les figures 5 à 7 représentent schématiquement trois autres modes de réalisation du dispositif selon l'invention avec différentes formes d'électrolytes ;
- les figures 8 à 15 illustrent un exemple de réalisation d'un procédé de fabrication du dispositif de la figure 4 ;
- la figure 16 schématiquement un autre dispositif selon un exemple illustratif.

Dans toutes les figures, les éléments communs portent les mêmes numéros de référence.

Les figures 1 à 3 ont déjà été décrites en référence à l'état de la technique.

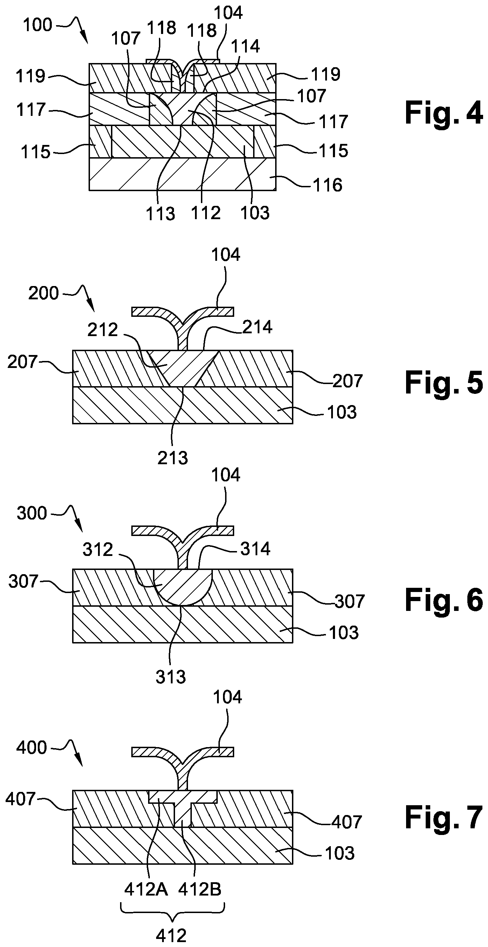

La figure 4 illustre un premier mode de réalisation d'un dispositif 100 selon l'invention.

Le dispositif 100 est formé par un empilement de type Métal / Conducteur ionique / Métal.

Le dispositif 100 comporte un électrolyte solide 112, par exemple à base de chalcogénure dopé tel que du GeS, disposé entre une électrode inférieure inerte 103, par exemple en Pt, formant une cathode inerte et une électrode supérieure 104 comportant une portion de métal ionisable, par exemple à base d'Ag, c'est-à-dire une portion de métal pouvant facilement former des ions métalliques (ici des ions Ag+), et formant une anode. Ce dispositif 100 comporte en outre des portions diélectriques latérales 107 disposées autour de l'électrolyte 112. Ces espaceurs diélectriques 107 sont eux-mêmes entourés de portions diélectriques 117.

L'électrode inerte 103 est isolée latéralement (par exemple par des espaceurs diélectriques 115) et repose sur une ligne métallique 116. Cette ligne métallique 116 peut par exemple faire partie d'une ligne d'accès (ligne de bits ou ligne de mots) dans le cas où le dispositif de mémoire résistive 100 selon l'invention est intégré dans une architecture de type « cross-bar ».

Une première solution pour contrôler la formation du filament conducteur au sein de l'électrolyte serait de réduire uniformément la taille de l'électrolyte. Plus le volume de l'électrolyte est petit, plus le filament est guidé dans sa croissance, et donc plus les caractéristiques électriques seront reproductibles. La formation du filament est contrainte par la taille réduite de l'électrolyte, proche de la taille du filament. Cependant, la réduction de la taille de l'électrolyte peut entraîner une dégradation des performances lorsque la taille de l'électrolyte est proche ou égale à celle du filament que l'on souhaite créer. Par exemple pour une opération d'effacement, il reste peu d'espace disponible dans l'électrolyte pour dissoudre le filament formé. Avantageusement, la forme de l'électrolyte 112 est choisie afin de diminuer la surface 113 du contact entre l'électrolyte 112 et l'électrode inerte 103 tout en conservant un volume d'électrolyte suffisant.

En d'autres termes, le volume de l'électrolyte 112 est asymétrique et choisi de sorte que la surface 113 de contact de l'électrolyte avec l'électrode inerte 103 soit strictement inférieure à la surface 114 de l'électrolyte 112 située du côté de l'électrode soluble 104.

Les flancs de l'électrolyte 112 sont ici concave arrondis avec une section mesurée parallèlement au plan des couche de l'empilement (et donc parallèlement aux plans de contact des électrodes 103 et 104) qui croit continument depuis la surface 113 de contact de l'électrolyte 112 avec l'électrode inerte 103 jusqu'à la surface 114 de l'électrolyte 112 du côté de l'électrode soluble 104. Cette forme est donnée à titre purement illustratif et nullement limitatif.

L'électrode soluble 104 est ici une électrode dont l'extrémité en contact avec la surface 114 de l'électrolyte 112 est réduite. En d'autres termes, la surface de l'extrémité de l'électrode soluble 104 en contact avec l'électrolyte 112 est inférieure à la surface disponible de l'électrolyte 112 de sorte qu'on obtient un confinement de la zone de contact de l'électrode soluble 104 sur l'électrolyte solide 112. Tout comme pour l'électrolyte 112, les flancs de l'électrode soluble 104 sont concave arrondis. Cette forme est donnée à titre purement illustratif et nullement limitatif.

Le dispositif 100 comporte en outre des portions diélectriques latérales 118 disposées autour de l'électrode soluble 104. Ces espaceurs diélectriques 118 sont eux-mêmes entourés de portions diélectriques 119.

Le confinement de l'électrode supérieure soluble 104 permet de contrôler la formation du filament conducteur. Plus la surface de contact 113 est petite, plus le filament sera guidé dans sa croissance, et donc plus les caractéristiques électriques seront reproductibles.

Selon ce mode de réalisation, on confine à la fois l'électrolyte 112 et l'électrode supérieure soluble 104. Ce double confinement permet de contrôler la taille et la position du filament en le guidant dans sa croissance lors de l'opération de SET de la mémoire CBRAM. Le confinement de l'électrolyte permet de réduire l'espace disponible pour le filament (et donc de guider le filament) et le confinement de l'électrode supérieure permet de générer un pic de champ électrique pendant l'opération de SET assurant une croissance préférentielle verticale du filament.

En choisissant une telle géométrie pour l'électrolyte 112 et l'électrode soluble 104, le dispositif CBRAM 100 selon l'invention permet non seulement d'obtenir un filament localisé mais également de conserver un volume d'électrolyte suffisant pour faciliter l'effacement.

Le filament est ainsi guidé dans sa croissance de par le rétrécissement de l'extrémité de l'électrode soluble 104 en contact avec la surface utile 114 de l'électrolyte 112 et le confinement de la zone 113 de contact de l'électrolyte 112 avec l'électrode inerte 103, les caractéristiques électriques étant ainsi reproductibles.

L'état mémoire du dispositif mémoire CBRAM 100 résulte de la différence de résistivité électrique entre deux états : ON et OFF. A l'état OFF, les ions métalliques (par exemple ici des ions Ag+ pour une électrode soluble en Ag) issus de la portion de métal ionisable sont dispersés dans tout l'électrolyte solide 112. Ainsi, aucun contact électrique n'est établi entre l'électrode soluble 104 et l'électrode inerte 103, c'est-à-dire entre la portion de métal ionisable et l'électrode inférieure. L'électrolyte solide 112 forme une zone électriquement isolante de grande résistivité entre l'anode 104 et la cathode 103.

Lorsqu'un potentiel V positif est appliqué sur l'électrode soluble supérieure 104, une réaction d'oxydo-réduction a lieu à cette électrode, créant des ions mobiles.

Dans le cas d'une électrode 104 d'Argent, la réaction suivante a lieu :

Ag → Ag⁺ + e⁻.

Il faut pour cela que le potentiel V appliqué à l'électrode soluble 104 soit supérieur au potentiel redox de l'électrode 104 en question (généralement de l'ordre de plusieurs centaines de mV).

Le fait d'avoir un confinement de l'électrode 104 entraîne un effet de pointe sur cette électrode et une augmentation locale du champ électrique créé lors de cette opération de SET. Cette augmentation très localisée du champ permet de guider les ions Ag⁺ et donc le filament dans sa formation. Les ions Ag⁺ se déplacent alors dans l'électrolyte 112 sous l'effet du champ électrique appliqué et localisé. Arrivés à l'électrode inerte 103, les ions Ag⁺ sont réduits de par la présence d'électrons fournis par l'électrode, entraînant la croissance d'un filament métallique selon la réaction suivante :

Ag⁺ + e- → Ag

Ce filament croit préférentiellement dans la direction de l'électrode soluble 104.

De par le rétrécissement (ou confinement) de l'électrolyte 112 à mesure que l'on se rapproche de l'électrode inerte 103, les ions Ag⁺ sont contraints dans leur déplacement de sorte que la formation du filament est parfaitement contrôlée. C'est ici l'amorce de création du filament au niveau de l'électrode inerte 103 qui est contrôlée grâce à la taille réduite de la surface de contact 113 entre l'électrolyte 112 et la cathode 103.

La mémoire 100 passe alors dans l'état ON lorsque le filament permet le contact entre les deux électrodes 103 et 104, rendant l'empilement conducteur. Cette phase est appelé SET de la mémoire.

Pour passer à l'état OFF (phase de RESET de la mémoire), une tension V négative est appliquée sur l'électrode supérieure 104, entrainant la dissolution du filament conducteur sous forme d'ions Ag⁺. Grâce au dispositif 100 selon l'invention et à la forme évasée de l'électrolyte 112, on conserve un volume suffisant dans la partie supérieure de l'électrolyte (i.e. du côté de l'électrode soluble 104) vers laquelle se dirigent les ions lors de la dissolution de façon à faciliter l'effacement, les ions se redéposant sur l'électrode soluble 104.

La forme de l'électrolyte 112 avec des flancs de forme arrondie concave est donnée à titre purement illustratif étant entendu que d'autres formes d'électrolytes sont parfaitement envisageables ; ainsi, trois autres exemples d'électrolytes sont illustrés sur les figures 5 à 7.

Comme pour l'électrolyte 112 du dispositif 100, les électrolytes 212 et 312 appartenant respectivement aux dispositifs CBRAM 200 et 300 des figures 5 et 6 présentent une forme choisie de sorte que la section de l'électrolyte mesurée parallèlement au plan des couche de l'empilement (et donc parallèlement aux plans de contact des électrodes 103 et 104) croit continument depuis la surface 213 (respectivement 313) de contact de l'électrolyte 212 (respectivement 312) avec l'électrode inerte 103 jusqu'à la surface 214 (respectivement 314) de contact de l'électrolyte 212 (respectivement 312) avec l'électrode soluble 104.

L'électrolyte 212 possède une forme générale globalement pyramidale tandis que l'électrolyte 312 présente des flancs de forme arrondie convexe. Le principe demeure que la forme la plus efficace est celle qui combine une faible surface d'électrolyte du côté de l'électrode inerte et un fort volume d'électrolyte du côté de l'électrode soluble.

Selon un autre mode de réalisation illustré en figure 7, le dispositif CBRAM 400 selon l'invention comporte un électrolyte 412 présentant un première partie 412B de section constante en contact avec l'électrode inerte 103 et une deuxième partie 412A de section constante en contact avec l'électrode soluble 104, lesdites sections étant mesurées parallèlement au plan des couche de l'empilement (et donc parallèlement aux plans de contact des électrodes 103 et 104). La section constante de la première partie 412B est choisie inférieure à la section constante de la deuxième partie 412A.

Les formes des électrolytes (cf. notamment figures 4, 5 et 6) peuvent être obtenues par la réalisation d'espaceur dans un via de dimensions relâchées (donc compatible avec une technologie standard). La forme de l'espaceur obtenue dépend des conditions de gravure (connues par l'homme du métier) qui permettent de contrôler la pente de l'électrolyte dans le diélectrique.

Les formes des électrolytes (cf. notamment figure 7) peuvent également être obtenues par réalisation de lithographies successives ou par gravure auto-alignée de matériaux montrant une vitesse de gravure différente pour élargir le volume de l'électrolyte au niveau de l'électrode soluble, tout en gardant une zone de contact réduite entre l'électrolyte et l'électrode inerte.

On notera que dans chacun des cas, les espaceurs diélectriques 107 (respectivement 207, 307 et 407) et 118 ont des flancs qui s'adaptent aux flancs respectifs de l'électrolyte et de l'électrode de confinement. En d'autres termes, il n'y a pas de discontinuité de matériau. En pratique, l'électrolyte et l'électrode de confinement sont chacun déposés dans la cavité formée par leurs espaceurs respectifs.

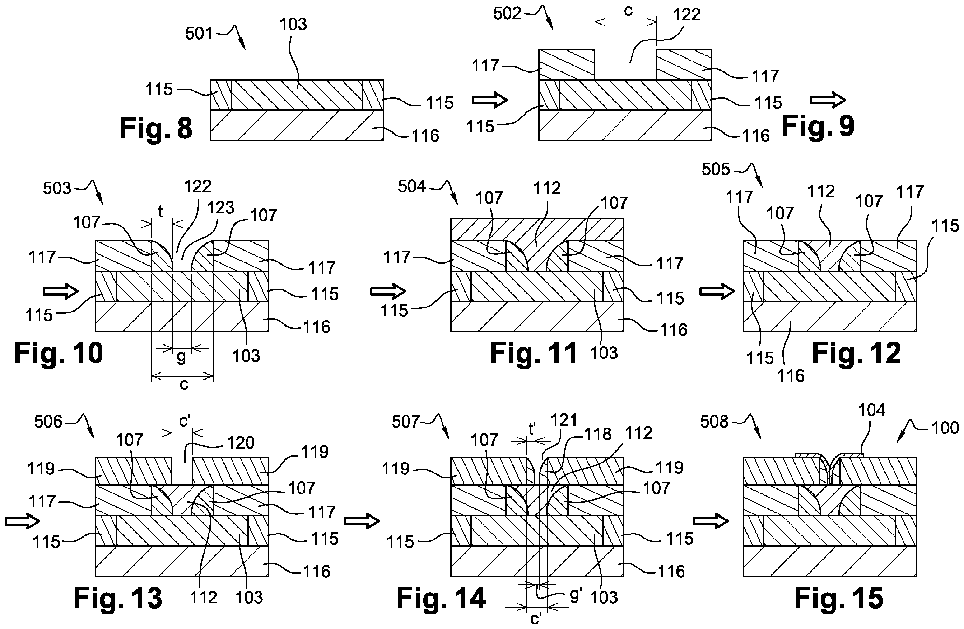

Les figures 8 à 15 illustrent les étapes principales d'un procédé de fabrication du dispositif 100 de la figure 4.

Selon l'étape 501 représentée en figure 8, on commence par réaliser une ligne métallique 116, par exemple sur un substrat en Si ou sur des transistors MOS d'un niveau logique inférieur non représenté. Comme mentionné plus haut, cette ligne métallique peut faire office de ligne de mots ou de bits dans une structure matricielle de type « cross-bar » intégrant plusieurs dispositifs mémoire selon l'invention. Cette ligne 116 peut être réalisée de façon connue par une étape de gravure après photolithographie et formée par exemple à partir de Cu ou d'un alliage AlCu ou AlSi.

Selon cette étape 501, on réalise également l'électrode métallique inerte inférieure 103. Cette électrode 103 est par exemple obtenue par un procédé de type damascène qui consiste à graver au travers d'un masque en résine, un VIA dans un diélectrique 115. Le VIA est ensuite recouvert par le métal puis on retire l'excédent de métal par un polissage mécano-chimique CMP pour obtenir l'électrode inerte 103. Le diélectrique 115 isolant le VIA peut être par exemple du SiO₂, déposé sur le substrat dont l'épaisseur peut être comprise entre 50 et 100nm. L'électrode inerte 103 est par exemple réalisée en Pt, TiN ou W.

Selon l'étape 502 représentée en figure 9, on dépose une couche de diélectrique (par exemple une couche de Si₃N₄ présentant une épaisseur comprise entre 50nm 100nm). Cette couche diélectrique est ensuite gravée après photolithographie de manière à réaliser une seconde cavité 122 entourée par des portions diélectriques 117. La cavité 122 présente ici une largeur c inférieure à celle du VIA métallique 103 ; on notera toutefois que les dimensions de cette seconde cavité ne sont pas critiques pour la mise en oeuvre du procédé.

Selon l'étape 503 représentée en figure 10, on dépose un diélectrique dans la cavité 122. Ce diélectrique est gravé (par exemple par une gravure anisotrope) de manière à réaliser les espaceurs 107 localisés sur les flancs de la seconde cavité 122.

La forme des espaceurs 107 (et notamment les flancs des espaceurs 107) obtenue dépend des conditions de gravure (connues par l'homme du métier) et va permettre par la suite de définir la forme complémentaire de l'électrolyte déposé dans le diélectrique.

La largeur t de chacun des espaceurs 107 est égale à la largeur (ou épaisseur) du diélectrique déposé ; cette largeur t est choisie par rapport à la largeur c de la seconde cavité 122 de manière à laisser un espace 123 de largeur g dans la seconde cavité 122 formant une ouverture sur l'électrode métallique inerte inférieure 103. Ainsi, les dimensions t, c et g sont choisies de manière à avoir un espace 123 à la dimension la plus faible possible, de l'ordre de quelques nm : cet espace 123 définit la surface de contact entre l'électrolyte et l'électrode inerte. A titre d'exemple, on pourra prendre le triplet suivant : c=100nm ; t=45nm ; g=10nm. Comme mentionné plus haut, la dimension du diélectrique 117 peut être relâchée: la longueur de la deuxième cavité 122 n'est pas critique et peut être de plus grande dimension. Le matériau diélectrique formant les espaceurs 107 est choisi de manière à ce que l'électrode métallique soluble ait un faible coefficient de diffusion dans ce matériau diélectrique. En effet, ces espaceurs 107 ne doivent pas agir comme un électrolyte. A titre d'exemple, dans le cas d'une électrode soluble d'Ag, on pourra choisir des espaceurs 107 en SiO₂.

Selon l'étape 504 représentée en figure 11, on dépose l'électrolyte solide 112 (par exemple GeS₂(50nm) ou SiO₂(10nm) ...).

Selon l'étape 505 représentée en figure 12, on procède à un polissage mécano-chimique CMP de la partie supérieure de l'électrolyte 112 (i.e. la partie localisée au-dessus de la cavité 123) de façon à obtenir un électrolyte 112 de volume plus réduit.

Selon une alternative non représentée, il est également possible d'obtenir une ouverture telle que l'ouverture 123 en n'utilisant pas d'espaceurs 107 et en passant par d'autres méthodes telles que le fluage de résine. Selon cette dernière technique, on conserve une couche de matériau diélectrique 117 (figure 9) sans réaliser d'ouverture 118. On réalise un motif de résine fluée au niveau de la zone de réalisation de l'électrolyte. Ce motif de résine présente sensiblement la même forme que la partie inférieure de l'électrolyte 112. Ce type de motif peut être notamment obtenu en utilisant une résine de type « Deep UV » étalée puis lithographiée. On insole (par exemple par des rayonnements UV) une fraction de la résine au-travers d'un masque comportant une partie transparente aux rayonnements UV à longueurs d'onde courtes (typiquement comprises entre 150 et 300nm) et une partie opaque aux rayonnements UV (absorbant les rayonnements UV) ; il se créé alors, par réaction photochimique, une image latente dans l'épaisseur de la résine photosensible. La résine est ensuite « développée ». Un recuit final est appliqué pour durcir le motif de résine ainsi formé. Après ces étapes de développement et de recuit, une température au-dessus de la température de transition vitreuse est appliquée afin de faire « fluer » la résine. On transfère ensuite la forme du motif de résine dans la couche diélectrique de manière à obtenir une ouverture présentant sensiblement la forme de la partie inférieure de l'électrolyte. Ce transfert est par exemple obtenu en effectuant une gravure plasma.

Selon l'étape 506 représentée en figure 13, on dépose une couche de diélectrique (par exemple une couche de Si₃N₄ ou de SiO₂ présentant une épaisseur comprise entre 50nm 100nm). Cette couche diélectrique est ensuite gravée après photolithographie de manière à réaliser une cavité 120 entourée par des portions diélectriques 119. La cavité 120 présente ici une largeur c' inférieure à celle du VIA métallique 103 ; on notera toutefois que les dimensions de la cavité 120 ne sont pas critiques pour la mise en oeuvre du procédé.

Selon l'étape 507 représentée en figure 14, on dépose un diélectrique dans la cavité 120. Ce diélectrique est gravé (par exemple par une gravure anisotrope) de manière à réaliser les espaceurs 118 localisés sur les flancs de la cavité 120.

La forme des espaceurs 118 obtenue dépend des conditions de gravure et va permettre par la suite de définir la forme complémentaire de l'électrode soluble déposée dans le diélectrique.

La largeur t' de chacun des espaceurs 118 est égale à la largeur (ou épaisseur) du diélectrique déposé ; cette largeur t' est choisie par rapport à la largeur c' de la cavité 120 de manière à laisser un espace 121 de largeur g' dans la cavité 120 formant une ouverture réduite sur la surface de l'électrolyte solide 112. Ainsi, les dimensions t', c' et g' sont choisies de manière à avoir un espace 120 à la dimension la plus faible possible, de l'ordre de quelques nm : cet espace 120 définit la surface de contact entre l'électrode soluble et l'électrolyte. Le matériau diélectrique formant les espaceurs 118 est choisi de manière à ce que l'électrode métallique soluble ait un faible coefficient de diffusion dans ce matériau diélectrique. En effet, ces espaceurs 118 ne doivent pas agir comme un électrolyte. A titre d'exemple, dans le cas d'une électrode soluble d'Ag, on pourra choisir des espaceurs 118 en Si₃N₄.

Selon l'étape 508 illustrée en figure 15, l'électrode soluble supérieure 104 est déposée et gravée après photolithographie (par exemple, une épaisseur comprise entre 10nm et 50nm de Cu ou d'Ag) de sorte qu'on obtient le dispositif 100 tel que représenté en figure 4. L'effet de pointe ainsi réalisé au niveau de l'électrode supérieure entraîne une augmentation locale du champ électrique lors de l'opération de SET, ce qui permet de guider le filament et de contrôler sa position et donc de réduire les dispersions de taille et position du filament.

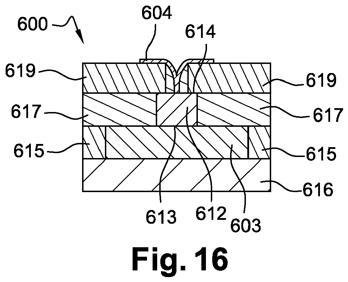

La figure 16 illustre un dispositif 600 qui est un exemple illustratif hors de l'invention. La différence entre le dispositif 100 de la figure 4 et le dispositif 600 de a figure 16 réside dans le fait que l'électrolyte du dispositif 600 n'est pas confiné, seule l'électrode soluble étant confinée.

Comme le dispositif 100, le dispositif 600 comporte un électrolyte solide 612 disposé entre une électrode inférieure inerte 603 et une électrode supérieure 604.

Le dispositif 600 est formé par un empilement de type Métal / Conducteur ionique / Métal.

Le dispositif 600 comporte un électrolyte solide 612, par exemple à base de chalcogénure dopé tel que du GeS, disposé entre une électrode inférieure inerte 603, par exemple en Pt, formant une cathode inerte et une électrode supérieure 604 comportant une portion de métal ionisable, par exemple à base d'Ag, c'est-à-dire une portion de métal pouvant facilement former des ions métalliques (ici des ions Ag+), et formant une anode. Ce dispositif 600 comporte en outre des portions diélectriques latérales 617 disposées autour de l'électrolyte 612.

L'électrode inerte 603 est isolée latéralement (par exemple par des espaceurs diélectriques 615) et repose sur une ligne métallique 616.

Ici, l'électrolyte 612 a une forme standard sans confinement (i.e une forme sensiblement parallélépipédique).

En d'autres termes, le volume de l'électrolyte 612 est ici symétrique et choisi de sorte que la surface 613 de contact de l'électrolyte avec l'électrode inerte 603 soit sensiblement égale à la surface 614 disponible de l'électrolyte 612 située du côté de l'électrode soluble 604.

L'électrode soluble 604 est une électrode dont l'extrémité en contact avec la surface 614 de l'électrolyte 612 est réduite. En d'autres termes, la surface de l'extrémité de l'électrode soluble 604 en contact avec l'électrolyte 612 est inférieure à la surface totale disponible de l'électrolyte 612 de sorte qu'on obtient un confinement de la zone de contact de l'électrode soluble 604 sur l'électrolyte solide 612. Les flancs de l'électrode soluble 604 sont concave arrondis. Cette forme est donnée à titre purement illustratif et nullement limitatif.

Le dispositif 600 comporte en outre des portions diélectriques latérales 618 disposées autour de l'électrode soluble 604. Ces espaceurs diélectriques 618 sont eux-mêmes entourés de portions diélectriques 619.

Le dispositif 600 peut être obtenu selon un procédé analogue à celui décrit en référence aux figures 8 à 15, seules les étapes relatives à la mise en forme d'un électrolyte confiné étant supprimées.

Bien entendu, le dispositif et le procédé selon l'invention ne sont pas limités aux modes de réalisation qui viennent d'être décrits à titre indicatif et nullement limitatif en référence aux figures 1 à 16.

Ainsi, même si l'invention a été décrite de manière illustrative à l'aide d'un filament, il est entendu que le dispositif selon l'invention peut comporter une pluralité de filaments répartis au sein de l'électrolyte.

On notera en outre que le dispositif doit contenir une électrode soluble et une électrode inerte, chacune de ces électrodes pourra indifféremment être positionnée comme électrode supérieure ou inférieure, l'électrode inerte étant disposée du côté de la zone la plus étroite de l'électrolyte et l'électrode soluble étant positionnée du côté du grand volume de l'électrolyte solide.

## Revendications

1. Dispositif électronique (100) comportant :
- une première électrode (103) en matériau inerte ;
- une deuxième électrode (104) en matériau soluble ;
- un électrolyte (112) solide à base d'un matériau conducteur ionique, les première et deuxième électrodes (103, 104) étant respectivement en contact avec l'une des faces de l'électrolyte (112) de part et d'autre dudit électrolyte (112), la deuxième électrode (104) étant apte à fournir des ions mobiles circulant dans l'électrolyte (112) vers la première électrode (103) pour former un filament conducteur entre la première électrode (103 et la deuxième électrode (104) lorsqu'une tension est appliquée entre la première et la deuxième électrodes ;
ledit dispositif (100) étant **caractérisé en ce que** la deuxième électrode (104) en matériau soluble est une électrode de confinement, ladite électrode de confinement comportant une surface d'extrémité en contact avec l'électrolyte (112) inférieure à la surface disponible de l'électrolyte (112) de sorte qu'on obtient un confinement de la zone de contact de ladite électrode de confinement sur l'électrolyte solide, et **en ce que** le volume de l'électrolyte (112) est choisi de sorte que la surface de la première extrémité de l'électrolyte (112) en contact avec la première électrode (103) est strictement inférieure à la surface de la deuxième extrémité de l'électrolyte en vis-à-vis de la première extrémité.

2. Dispositif selon l'une des revendications précédentes **caractérisé en ce que** la section de l'électrode de confinement mesurée parallèlement au plan de contact de l'électrolyte avec l'électrode de confinement croit continument depuis le plan de contact sur au moins une partie de la hauteur de ladite électrode de confinement.

3. Dispositif selon l'une des revendications précédentes **caractérisé en ce que** le volume de l'électrolyte est choisi de sorte que la surface de la première extrémité de l'électrolyte en contact avec la première électrode est strictement inférieure à la surface de la deuxième extrémité de l'électrolyte en vis-à-vis de la première extrémité.

4. Dispositif selon la revendication précédente **caractérisé en ce que** la section de l'électrolyte mesurée parallèlement au plan de contact dudit électrolyte avec la première électrode croit continument depuis le plan de contact sur au moins une partie de la hauteur de l'électrolyte.

5. Dispositif selon la revendication 3 **caractérisé en ce que** l'électrolyte présente un première partie de section constante en contact avec la première électrode poursuivie par une deuxième partie de section constante, la section constante de la première partie étant inférieure à la section constante de la deuxième partie, lesdites sections constantes étant mesurées parallèlement aux plans de contact de l'électrolyte avec les première et deuxième électrodes.

6. Dispositif selon l'une des revendications précédentes **caractérisé en ce qu'**il comporte des moyens isolants entourant l'électrolyte sur au moins une partie de sa hauteur.

7. Dispositif selon l'une des revendications précédentes **caractérisé en ce qu'**il comporte des moyens isolants entourant l'électrode de confinement sur au moins une partie de sa hauteur.

8. Procédé de fabrication du dispositif selon la revendication 7 **caractérisé en ce qu'**il comporte :
- une étape de réalisation d'une ouverture dans un matériau isolant, ladite ouverture ayant la forme de ladite électrode de confinement ;
- une étape de remplissage de ladite ouverture par un matériau formant ladite électrode.

9. Procédé selon la revendication précédente **caractérisé en ce que** ladite ouverture est obtenue par gravure anisotrope du matériau isolant.

## Patentansprüche

1. Elektronische Vorrichtung (100), umfassend:
- eine erste Elektrode (103) aus inertem Material;
- eine zweite Elektrode (104) aus löslichem Material;
- ein festes Elektrolyt (112) basierend auf einem ionischen leitenden Material, wobei die erste und zweite Elektrode (103, 104) jeweils in Kontakt mit einer der Seiten des Elektrolyts (112) auf jeder Seite des genannten Elektrolyts (112) sind, wobei die zweite Elektrode (104) geeignet ist, mobile Ionen zu liefern, die in dem Elektrolyt (112) zu der ersten Elektrode (103) zirkulieren, um einen leitenden Draht zwischen der ersten Elektrode (103) und der zweiten Elektrode (104) zu bilden, wenn eine Spannung zwischen der ersten und der zweiten Elektrode angewendet wird;
wobei die genannte Vorrichtung (100) **dadurch gekennzeichnet ist, dass** die zweite Elektrode (104) aus löslichem Material eine Sicherungselektrode ist, wobei die genannte Sicherungselektrode eine Endfläche mit Kontakt zu dem Elektrolyt (112), die kleiner ist als die verfügbare Fläche des Elektrolyts (112), derart umfasst, dass eine Sicherung des Kontaktbereichs der genannten Sicherungselektrode auf dem genannten festen Sicherungselektrolyt erhalten wird und dass das Elektrolytvolumen (112) derart ausgewählt ist, dass die Fläche des ersten Endes des Elektrolyts (112) mit Kontakt zu der ersten Elektrode (103) strikt kleiner ist als die Fläche des zweiten Endes des Elektrolyts gegenüber dem ersten Ende.

2. Vorrichtung gemäß einem der voranstehenden Ansprüche, **dadurch gekennzeichnet, dass** der Abschnitt der Sicherungselektrode parallel zur Kontaktebene des Elektrolyts gemessen von der Kontaktebene auf wenigstens einem Teil der Höhe des genannten Sicherungselektrolyts mit dem Sicherungselektrolyt konstant anwächst.

3. Vorrichtung gemäß einem der voranstehenden Ansprüche, **dadurch gekennzeichnet, dass** das Volumen des Elektrolyts derart ausgewählt ist, dass die Fläche des ersten Endes des Elektrolyts mit Kontakt zu der ersten Elektrode strikt kleiner ist als die Fläche des zweiten Endes des Elektrolyts gegenüber dem ersten Ende.

4. Vorrichtung gemäß dem voranstehenden Anspruch, **dadurch gekennzeichnet, dass** der Abschnitt des Elektrolyts, parallel zur Kontaktebene des genannten Elektrolyts gemessen, ab der Kontaktebene auf wenigstens einem Teil der Höhe des Elektrolyts mit der ersten Elektrode kontinuierlich wächst.

5. Vorrichtung gemäß Anspruch 3, **dadurch gekennzeichnet, dass** das Elektrolyt einen ersten konstanten Abschnittsteil mit Kontakt zu der ersten Elektrode aufweist, auf den ein zweiter konstanter Abschnittsteil folgt, wobei der konstante Abschnitt des ersten Teils kleiner ist als der konstante Abschnittsteil des zweiten Teils, wobei die genannten konstanten Abschnitte parallel zu den Kontaktebenen des Elektrolyts mit der ersten und zweiten Elektrode gemessen werden.

6. Vorrichtung gemäß einem der voranstehenden Ansprüche, **dadurch gekennzeichnet, dass** sie isolierende Mittel umfasst, die das Elektrolyt auf wenigstens einem Teil seiner Höhe umgeben.

7. Vorrichtung gemäß einem der voranstehenden Ansprüche, **dadurch gekennzeichnet, dass** sie isolierende Mittel umfasst, die die Sicherungselektrode auf wenigstens einem Teil ihrer Höhe umgeben.

8. Herstellungsverfahren der Vorrichtung gemäß Anspruch 7, **dadurch gekennzeichnet, dass** es umfasst:
- einen Realisierungsschritt einer Öffnung aus einem isolierenden Material, wobei die genannte Öffnung die Form der genannten Sicherungselektrode hat;
- einen Befüllungsschritt der genannten Öffnung durch ein Material, das die genannte Elektrode bildet.

9. Verfahren gemäß dem voranstehenden Anspruch, **dadurch gekennzeichnet, dass** die genannte Öffnung durch anisotrope Gravur des isolierenden Materials erhalten wird.

## Claims

1. Electronic device (100) comprising:
- a first electrode (103) made of an inert material;
- a second electrode (104) made of a soluble material;
- a solid electrolyte (112) with an ionic conducting material base, with the first and second electrodes (103, 104) being respectively in contact with one of the faces of the electrolyte (112) on either side of said electrolyte (112), with the second electrode (104) being able to supply mobile ions circulating in the electrolyte (112) to the first electrode (103) in order to form a conducting filament between the first electrode (103) and the second electrode (104) when a voltage is applied between the first and the second electrodes;
said device (100) being **characterised in that** the second electrode (104) made of a soluble material is a confinement electrode, said confinement electrode comprising an end surface in contact with the electrolyte (112) less than the available surface of the electrolyte (112) in such a way that a confinement is obtained of the contact zone of said confinement electrode on the solid electrolyte, and **in that** the volume of the electrolyte (112) is chosen in such a way that the surface of the first end of the electrolyte (112) in contact with the first electrode (103) is strictly less than the surface of the second end of the electrolyte facing the first end.

2. Device according to one of the preceding claims **characterised in that** the section of the confinement electrode measured parallel to the contact plane of the electrolyte with the confinement electrode increases continuously from the contact plane over at least a portion of the height of said confinement electrode.

3. Device according to one of the preceding claims **characterised in that** the volume of the electrolyte is chosen in such a way that the surface of the first end of the electrolyte in contact with the first electrode is strictly less than the surface of the second end of the electrolyte facing the first end.

4. Device as claimed in the preceding claim **characterised in that** the section of the electrolyte measured parallel to the contact plane of said electrolyte with the first electrode increases continuously from the contact plane over at least a portion of the height of the electrolyte.

5. Device according to claim 3 **characterised in that** the electrolyte has a first portion of constant section in contact with the first electrode continued by a second portion of constant section, with the constant section of the first portion being less than the constant section of the second portion, said constant sections being measured parallel to the contact planes of the electrolyte with the first and second electrodes.

6. Device according to one of the preceding claims **characterised in that** it comprises insulating means surrounding the electrolyte over at least one portion of its height.

7. Device according to one of the preceding claims **characterised in that** it comprises insulating means surrounding the confinement electrode over at least one portion of its height.

8. Method for manufacturing the device according to claim 7 **characterised in that** it comprises:
- a step of carrying out an opening in an insulating material, said opening having the shape of said confinement electrode;
- a step of filling said opening with a material forming said electrode.

9. Method as claimed in the preceding claim **characterised in that** said opening is obtained by anisotropic etching of the insulating material.
